(19) Europäisches Patentamt
European Patent Office
Office européen des brevets

(11) Publication number: **0 201 982 A2**

(12) # EUROPEAN PATENT APPLICATION

(21) Application number: 86200830.7

(22) Date of filing: 14.05.86

(51) Int. Cl.[4]: H 03 M 3/02

(30) Priority: 15.05.85 US 734417

(43) Date of publication of application: 20.11.86 Bulletin 86/47

(84) Designated Contracting States: DE FR GB IT NL

(71) Applicant: N.V. Philips' Gloeilampenfabrieken
Groenewoudseweg 1
NL-5621 BA Eindhoven(NL)

(72) Inventor: Dhuyvetter, Timothy Alan
c/o INT. OCTROOIBUREAU B.V. Prof. Holstlaan 6
NL-5656 AA Eindhoven(NL)

(74) Representative: Peters, Rudolf Johannes et al,
INTERNATIONAAL OCTROOIBUREAU B.V. Prof. Holstlaan 6
NL-5656 AA Eindhoven(NL)

(54) **A delta modulation decoder.**

(57) A circuit for processing the control signal inputs for a delta modulation digital audio decoder wherein a reference voltage and a reference current are generated to cancel out variations in temperature, resistance, process variations and circuit voltages to yield a stable control signal current.

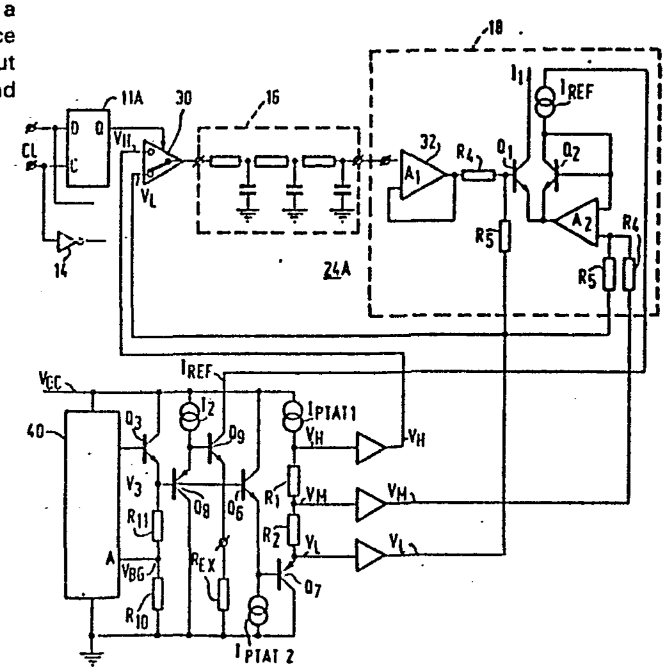


FIG.2

EP 0 201 982 A2

Croydon Printing Company Ltd.

A delta modulation decoder.

This invention relates to a delta modulation decoder comprising :

- storage means to receive and store temporarily a stream of logarithmically encoded control bits for the encoder
- filter means to detect the average dc voltage of the duty cycle of said control bit stream
- and exponentiator means to convert said voltage exponentially to a control signal current, which means comprise a transistor having a base for applying the output voltage of the filter and having a collector for supplying the said control signal current.

Such a delta modulation decoder may be used in high quality audio systems and in particular in the Dolby Laboratories Digital Audio Systems, suitable for high quality transmission of audio data in applications such as direct broadcast satellite, cable TV and multipoint distribution systems. This invention particularly is related to a decoder for the receiver of a Dolby transmission, the decoder having input logic and linear circuits capable of decoding two channels of a delta modulated digital data.

Such a delta modulation decoder is known from the paper "A digital audio system for broadcast and prerecorded media" presented at the 75the convention of the Audio Engineering Society on March 27/30,1984.

The Dolby Digital Audio System encoder produces three data bit streams that represent the audio information to be transmitted. Two of these streams are control data bits, while one stream is the audio data bit stream. Clock bits are also transmitted by the encoder. Since each of the three data bit streams can be several channels of time multiplexed data, the clock is used as a strobe to separate two channels of data.

The two control data bit streams for each channel are for step-size and system de-emphasis control. Information for the control data is encoded logarithmically in the duty cycle of the bit stream.

Low-pass filters are used to detect the average of DC value of the duty cycle. The resulting voltage is then exponentiated to expand the control signal into a larger range. The collector current of the actual exponentiating transistor is the control signal current. To obtain an accurate control signal current it is necessary to have precise control of the pulse height to be filtered and to properly bias the exponentiating transistor. It is therefore the object of the invention to provide a control signal current that is independent of temperature, voltage and resistance variations.

According to the invention a delta modulation decoder is characterized in that the decoder further comprises:

- a bandgap voltage generator to generate precise high, medium and low voltages in conjunction with a current proportional to absolute temperature and including current source means to generate a stable reference current,
- a switching amplifier for supplying to the filter means a bit stream with a precise high and low voltage using the voltages generated by said bandgap voltage generator dependent on the output of the storage means,
- and a reference voltage generator for generating a reference voltage to be applied to the emitter of said exponentiator transistor using the medium and low voltages and the reference current by said bandgap voltage generator.

The temperature and process spread compensation technique according to the invention allows the control signal within the circuit to be relatively independent of variations in temperature, resistance and voltage. The effect of this compensation is to allow the use of the circuit over a wide temperature range without the loss of performance.

The invention will be explained in greater detail by reference to the accompanying drawings, in which

Figure 1 is a circuit diagram of a known delta modulator decoder, and

Figure 2 is a circuit diagram of the input logic, the reference generator and a exponentiator circuit according to the invention for use in the decoder of Figure 1.

In Figure 1 the basic-scheme of the known delta-demodulation decoder is shown, which is designed for use in the Dolby

Laboratories Digital Audio System, which is suitable for high quality transmission of audio data.

In the encoder of this system the step-size or unit of quantization is made variable and increases with increasing slope of the input audio signal. The operation of the encoder is equivalent to sampling and quantizing an audio-waveform which has been multiplied by a further waveform representing the variation of step-size. The encoder is preceded with a variable emphasis circuit which in combination with the complementary de-emphasis circuit in the decoder provides a noise reduction and thus an increase in the signal-to-noise ratio. The encoder thus produces three data bit streams. One is the audio data bit stream (AD) and the other two are the control data bit streams for the step-size control (SSD) and the system de-emphasis (SBD) respectively. A clock signal (CL) is also transmitted. The decoder receives the transmitted output of the encoder. Since each of the data bit streams can be several channels of time multiplexed data, the clock is used as a strobe to seperate two channels of data. The components for these two channels are indicated with suffix A and B respectively. The duplicate components for channel B will not be discussed and are only shown schematically in the drawings.

Six edge triggered D flipflops 10,11 and 12 are used as input latches to store two channels of audio and control data. The flipflops 10A,11A and 12A are strobed by the clock signal CL and are used to store the first channel. The clock signal CL is inverted by means of an inverter 14 to strobe the second channel.

The step-size control bit stream (SSD) contains the required step-size which is encoded logarithmically in the duty cycle of the bit stream. It is decoded by a decoder circuit 24A, in which a three-pole low-pass filter 16 is used to detect the average or DC value of the duty cycle. The resultant voltage is then exponentiated to expand the control signal $I_{SS}$ into a range approaching 50 dB by means of an exponentiator circuit or anti-log circuit 18, which is basically formed by a bipolar transistor. The control signal $I_{SS}$ is multiplied by the audio data bits (+1 or -1) in multiplier 17 and subsequently fed to integrator 19. The output signal of the integrator 19 is supplied to a de-emphasis circuit 20 at the output 21 of which the analog audio output is obtained.

The de-emphasis control bit stream (SBD) contains the logarithm of the cut-off frequency of a variable high-pass filter in the de-emphasis circuit 20. This bit stream is decoded by a decoder circuit 25A which is substantially indentical with the step-size decoder circuit 24A. The control signal $I_{SB}$ controls the cut-off frequency of said filter.

In Figure 2 a decoder circuit in accordance with the invention for decoding the control data bit streams SSD or SBD for use in a delta-demodulation decoder of Figure 1 is shown. To maintain system accuracy it is necessary that the control signals $I_{SS}$ and $I_{SB}$ are substantially independent of temperature, voltage and resistance as well as manufacturing variations. To this end it is necessary to have precise control of the pulse height to be filtered by filter 16. This is accomplished by using a switching amplifier 30 to drive the low-pass filter 16. The output of the flipflop 11A (or 12A) sets the switching rate between two voltage levels $V_L$ and $V_H$. These voltages are generated in the bandgap reference current 40 which produces a voltage $V_{BG}$ at terminal A, that is nearly independent of temperature, supply and process variations. The voltage $V_{BG}$ is sealed up to $V_3$ by means of resistors R10,R11 and transistor $Q_3$. Such a circuit delivering a voltage $V_3$ is, for example, described in IEEE j. Solid Circuits, Vol. SC-9 pp 388-393. Dec 1974. The voltage $V_3$ is supplied to the basis of an emitter follower transistor $Q_6$ having a current source $I_{pTAT2}$ in its emitter line, which supplies an output current proportional to the absolute temperature and subsequently to the basis of a complementary emitter follower transistor $Q_7$ having two resistors $R_1$, and $R_2$ and a current source $I_{pTAT1}$ in its emitter line. This results in the fixed reference voltage $V_L = V_3 - V_{BEQ6} + V_{BEQ7}$, which is substantially of temperature variations since transistors $Q_6$ and $Q_7$ show substantially the same temperature behaviour. The voltage $V_H$ is a temperature sensitive voltage chosen to compensate for the temperature changes in the base-to-emitter voltage of a transistor discussed infra. The voltage $V_M$ is chosen to be 40 % of the voltage $V_H - V_L$. The voltage $V_3$ is further applied to the basis of a transistor $Q_9$ _via_ an emitter follower transistor $Q_8$ having a current source $I_2$ in its emitter line. The transistor $Q_9$ has an external resistor $R_{EX}$ in its emitter line and generates a low temperature

coefficient current $I_{REF}$, which is used in the exponentiater circuit 18.

The control voltage at the output of the low-pass filter 16 is buffered by amplifier 32 and is subsequently attenuated by the voltage divider of resistors $R_4$ and $R_5$. The voltage buffered by amplifier 32 is a $V_H$ which is the average DC-value of the bit stream of the duty cycle. In this embodiment the resistors $R_4$ and $R_5$ are chosen such that $R_5/R_4 + R_5 = \frac{1}{9}$. Hence the attenuated voltage, which is input to the exponentiator is $(aV_H - V_L)/9$. This voltage is temperature dependent.

The actual exponentiating transistor is transistor $Q_1$ and its collector current is the control signal current designated $I_1$. This current is in effect either $I_{SS}$ or $I_{SB}$. To properly bias transistor $Q_1$ and the other exponentiating transistors, a reference voltage generator circuit is provided using transistor $Q_2$, amplifier $A_2$ and the reference current $I_{REF}$. Amplifier $A_2$ forces the base of transistor $Q_2$ to be equal to $(V_M - V_L)/9$, which is the voltage applied to the other input of amplifier $A_2$ by means of the second voltage divider with resistors $R_4$ and $R_5$. The base-emitter

voltage $V_{BE}$ of transistor $Q_2$ is $V_{BEQ2} = V_T$ and $\frac{I_{REF}}{I_{S2}}$.

$I_{S2}$ is the saturation current of transistor $Q_2$. Hence the emitter

voltage $V_E = \frac{V_M - V_L}{9} - V_T$ and $\frac{I_{REF}}{I_{S2}}$. The effect is to

force a current through transistor Q2 to obtain a base-emitter voltage for transistor Q2 to be used as a reference voltage for the exponentiator.

The output of the exponentiating transistor $Q_1$ is a current $I_1$, which, depending on the circuit, is either $I_{SS}$ (step-size control) or $I_{SB}$ (system de-emphasis control) and which is independent of temperature, internal resistance and power supply. The circuit achieves this goal in the following fashion. Referring to the definitions where "a" is the duty cycle, "c" is a constant and the equation $V_T = \frac{KT}{q}$, for the voltage equivalent of temperature, the

difference between the base emitter voltage of transistors $Q_1$ and $Q_2$ is expressed :

$$\Delta V_{be} = V_{be1} - V_{be2} = V_T \ln \frac{I_1}{I_{s1}} - V_T \ln \frac{I_{REF}}{I_{s2}} \quad (1)$$

Since :

$I_{s1} = I_{s2}$ for purposes of this exposition, therefore yields :

$$\Delta V_{be} = V_T \ln \frac{I_1}{I_{REF}} \quad . \quad (2)$$

Since the actual voltage at the bases of $Q_1$ and $Q_2$ is known, substituting these values in equation (3) yields :

$$\Delta V_{be} = \frac{aV_H - V_L}{9} - \frac{V_M - V_L}{9} = \frac{1}{9}(aV_H - V_M) = V_T \ln \frac{I_1}{I_{REF}} \quad (3)$$

From which equation (4) follows :

$$I_1 = I_R\, e^{\left[\frac{(aV_H - V_m)}{9\, V_T}\right]} = I_{REF}\, e^{\left[\frac{(aV_H - V_m)}{\frac{9\, KT}{q}}\right]} \quad (4)$$

At this point it should be remarked that the base currents of transistors $Q_1$ and $Q_2$ have been neglected because they have no substantial impact on the value of the current $I_1$, which is the output of the exponentiator. Equation (4) yields the value of $I_1$. To show that this value is independent of resistance and temperature we consider equations (5) through (8).

$$I_{PTAT} = c\,\frac{V_T}{R} = c\,\frac{KT}{q}\,\frac{1}{R} \qquad (5)$$

$$V_H - V_L = I_{PTAT}\,(R_1+R_2) = c\,\frac{KT}{q}\,\frac{(R_1+R_2)}{R} \qquad (6)$$

From equation (6) it can be shown that $V_H$ is not changed from variations in resistance.

$$V_M - V_L = I_{PTAT}\,(R_2) = c\,\frac{KT}{q}\,\frac{R_2}{R} \qquad (7)$$

$$aV_H - V_M = c\,\frac{KT}{q}\left[\frac{a(R_1+R_2) - R_2}{R}\right] \qquad (8)$$

Then substituting equation (8) into equation(4) yields equation (9) for the output current of the exponentiator.

$$I_1 = I_{REF}\,e^{\left[\frac{c\frac{KT}{q}\,\frac{(a(R_1+R_2) - R_2)}{R}}{9\,\frac{KT}{q}}\right]} \qquad (9)$$

From equation 9 it can be shown that $I_1$ is not changed from variations in temperature or resistance.

Then, cancelling

$$\frac{KT}{q} : I_1 = I_{REF}e\left[\frac{c(a(R_1+R_2) - R_2)}{9\ R}\right] \qquad (10)$$

The input signals to the exponentiator are purposely made temperature dependent and in particular dependent on the absolute temperature because the conversion of a voltage to a current is temperature dependent. Therefore, the two temperature dependencies are cancelled in the exponentiator. $V_H$ is temperature dependent because of $I_{PTAT}$. The resistance is cancelled out in the generation of $I_{PTAT}$ through $R_1$ and $R_2$ as shown in equation (6). Therefore, $V_H$ is independent of the resistance.

The result of this technique is that the performance of the IC will be constant in spite of variations of temperature, process spreadings, internal resistance and the supply voltage $V_{CC}$. The frequency response and the gain of the circuit are controlled by the transmitted control bits, which may have now been made independent of these variables since the output of the various exponentiators will be either $I_{SS}$ or $I_{SB}$.

Once the audio data is put into two channels in the circuit, it is sent to a multiplier circuit or variable impedance circuit as described with reference to Figure 1.

Thus the circuit and technique of the present invention provided the basis for a two channel decoder for use in the Dolby Digital Audio System.

# CLAIMS

A delta modulation decoder comprising
- storage means to receive and store temporarily a stream of logarithmically encoded control bits for the encoder
- filter means to detect the average dc voltage of the duty cycle of said control bit stream
- and exponentiator means to convert said voltage exponentially to a control signal current, which means comprise a transistor having a base for applying the output voltage of the filter and having a collector for supplying the said control signal current characterized in that the decoder further comprises :
- a bandgap voltage generator to generate precise high, medium and low voltages in conjunction with a current proportional to absolute temperature and including current source means to generate a stable reference current.
- a switching amplifier for supplying to the filter means a bit stream with a precise high and low voltage using the voltages generated by said bandgap voltage generator dependent on the output of the storage means,
- and a reference voltage generator for generating a reference voltage to be applied to the emitter of said exponentiator transistor using the medium and low voltages and the reference current by said bandgap voltage generator.

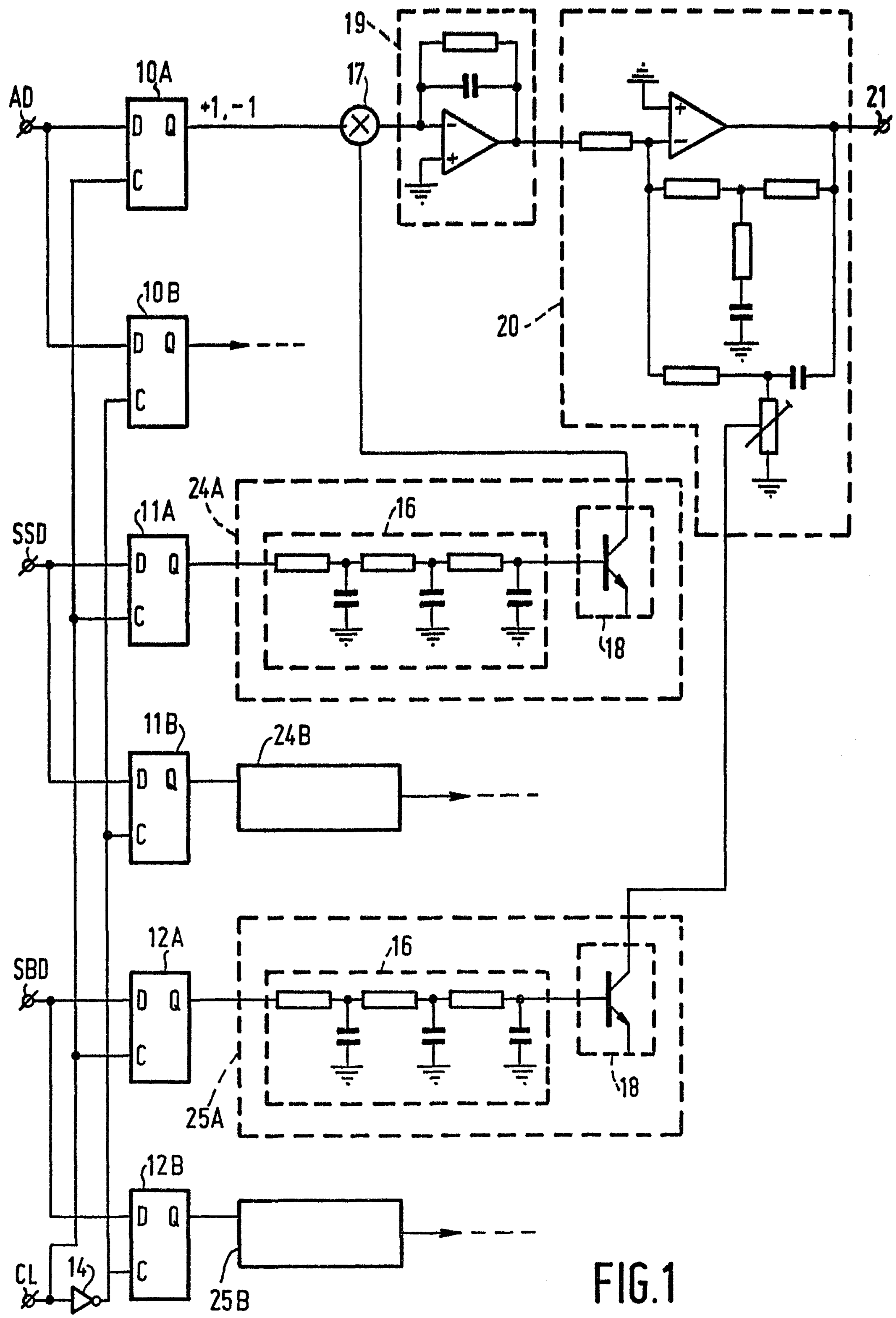
AD
10A
+1, -1
17
19
21
10B
20
SSD
11A
24A
16
18
11B
24B
SBD
12A
16
18
25A
12B
CL
14
25B
D
Q
C

FIG.1

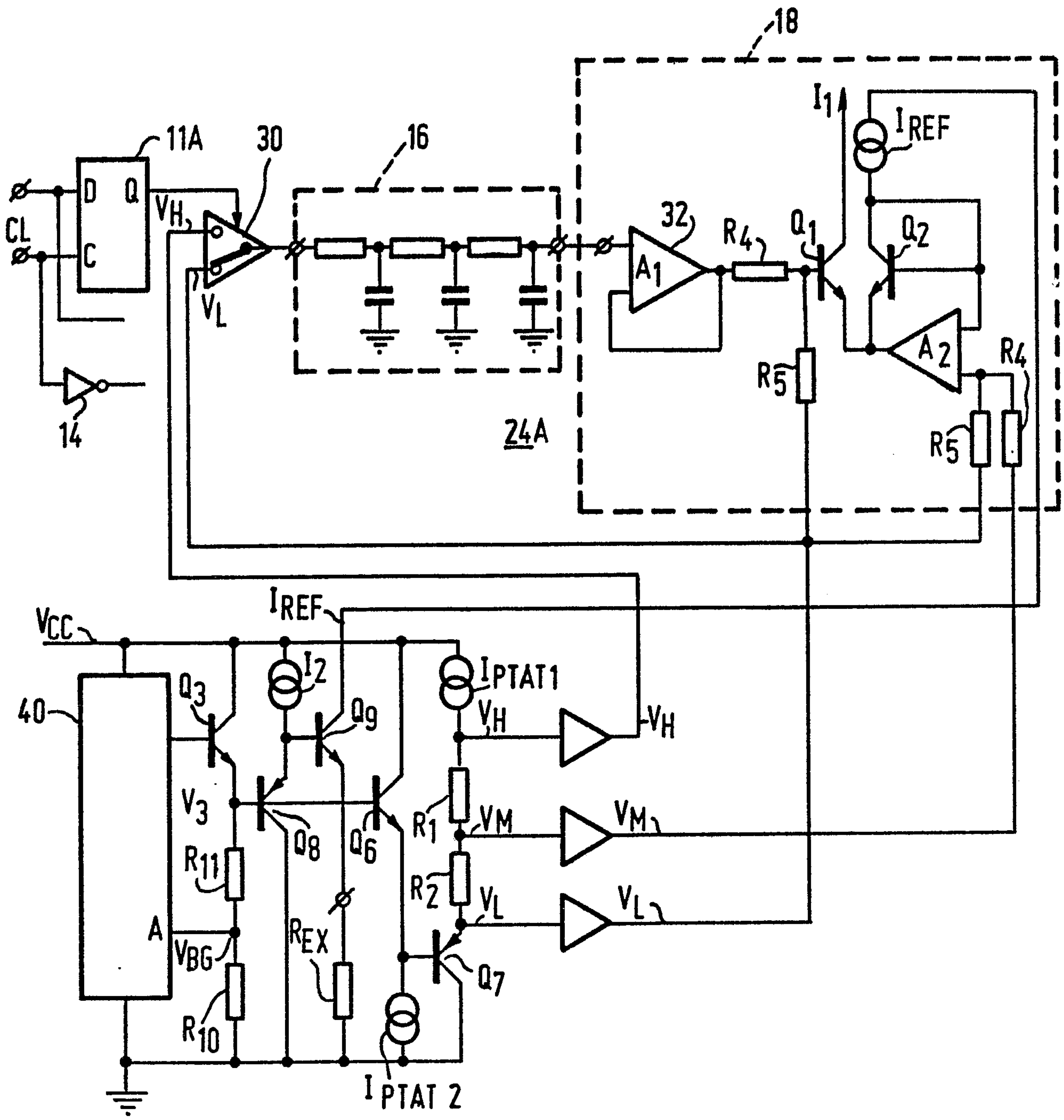

11A
30
16
18
D
Q
C
CL
VH
VL
14
24A
32
A1
R4
Q1
Q2
I1
IREF
A2
R5
R4
R5
VCC
IREF
40
Q3
I2
Q9
IPTAT1
VH
VH
V3
Q8
Q6
R1
VM
VM
R11
R2
VL
VL
A
VBG
REX
Q7
R10
IPTAT 2


FIG.2